# EUROPÄISCHE PATENTSCHRIFT

(11) **EP 0 360 727 B1**
(45) Veröffentlichungstag und Bekanntmachung des Hinweises auf die Patenterteilung: **12.10.1994**
(21) Anmeldenummer: 89730120.6
(22) Anmeldetag: 11.05.1989
(51) Int. Cl.: H01R 4/24, H01R 4/58

(54) **Kontaktelement für elektrische Leiter**
Contact element for electrical conductor
Elément de contact pour conducteur électrique

(30) Priorität: 22.09.1988 DE 3832497
(43) Veröffentlichungstag der Anmeldung: 28.03.1990
(73) Patentinhaber: KRONE Aktiengesellschaft, D-14167 Berlin (DE)
(72) Erfinder: Fitzgerald, Robert, Baeteau Bay. N. S. 2261 (US); Bramkamp, Wilhelm, D-1000 Berlin 47 (DE); Hegner, Gunter, D-1000 Berlin 27 (DE); Biederstedt, Lutz, D-1000 Berlin 37 (DE); Gerke, Dieter, D-1000 Berlin 27 (DE); Müller, Manfred, D-1000 Berlin 65 (DE); Radelow, Wolfgang, D-1000 Berlin 47 (DE)

(56) Entgegenhaltungen:
- EP-A- 0 144 758
- DE-A- 2 726 742
- US-A- 4 129 349

## Beschreibung

Die Erfindung bezieht sich auf ein Kontaktelement für elektrische Leiter gemäß dem Oberbegriff des Anspruches 1.

Aus der DE 27 26 742 A1 ist ein Verbindungsstück bekannt, bei dem das Kontaktelement aus Kunststoff ausgebildet ist.

Kontaktelemente für elektrische Leiter werden insbesondere bei Bauelementen der Fernmeldetechnik benötigt, wie Anschluß- und Trennleisten, Aderverbinder, Leiterplatten und dergleichen. Hierbei ist das Kontaktelement regelmäßig aus elektrisch leitfähigem, metallischem Werkstoff ausgebildet und in das aus einem Isolierstoff bestehende Bauelement eingesteckt. Als Isolierstoffe werden bei Anschluß- und Trennleisten sowie Aderverbindern regelmäßig thermoplastische Kunststoffe und bei Leiterplatten in Kunstharz getränkte Platten auf Papierbasis oder glasfaserverstärkte Kunstharze verwendet. Nachteilig hierbei ist, daß regelmäßig zwei Bauteile notwendig sind, nämlich ein Grundkörper aus Isolierstoff und das in diesen eingesteckte metallische Kontaktelement. Hierdurch werden die Herstellung und die Montage der bekannten Kontaktelemente für elektrische Leiter teuer und aufwendig.

Der Erfindung liegt von daher die Aufgabe zugrunde, ein Kontaktelement der gattungsgemäßen Art zu schaffen, das einfach und preiswert in der Herstellung ist und das die Herstellung und Montage der die Kontaktelemente verwendenden Bauelemente vereinfacht und verbilligt.

Die Lösung dieser Aufgabe ergibt sich aus den kennzeichnenden Merkmalen des Ansprüches 1. Erfindungsgemäß wird die Kontaktfläche des Kontaktelementes aus einem Isolierstoff, vorzugsweise dem Isolierstoff des Bauelementes selbst, ausgeformt und mit metallisierten Oberflächen versehen. Hierdurch können in einfacher und preiswerter Weise Kontaktelemente für elektrische Leiter geschaffen werden, die insbesondere für Bauelemente der Fernmeldetechnik bestimmt sind. Dabei kann das Kontaktelement in bevorzugter Weise einstückig gleichzeitig mit dem Bauelement aus einem einheitlichen Isolierstoff ausgeformt werden, wobei die Kontaktfläche anschließend mit einer metallisierten Oberfläche versehen wird.

Das erfindungsgemäße Kontaktelement eignet sich insbesondere zur Verwendung bei Leiterplatten, bei welchen das erfindungsgemäße Kontaktelement einstückig mit der Leiterplatte ausgeformt werden kann. Auch ist das erfindungsgemäße Kontaktelement mit Vorteil bei der Ausbildung von Aderverbindern einsetzbar. Dabei kann ein abisolierter Leiter zwischen sich konisch verjüngenden Kontaktflächen eingeklemmt werden.

In besonders bevorzugter Weise sind die Kontaktflächen mit den Kontaktschlitz bildenden Schneidkanten versehen, die aus dem Isolierstoff ausgeformt und mit metallisierten Oberflächen versehen sind und die beim Eindrücken eines nicht abisolierten Leiters dessen Ummantelung einschneiden und so mit den metallisierten Oberflächen einen elektrischen Kontakt zur Leiterseele herstellen.

Weitere vorteilhafte Ausgestaltungen der Erfindung ergeben sich aus den Unteransprüchen.

Die Erfindung ist nachfolgend anhand von sechs Ausführungsformen eines Kontaktelemtes für elektrische Leiter näher erläutert. Es zeigen:
- Fig. 1: eine Perspektivdarstellung eines Kontaktelementes in der ersten Ausführungsform,
- Fig. 2: eine Perspektivdarstellung eines aus einer Leiterplatte ausgeformten Kontaktelementes in der ersten Ausführungsform,
- Fig. 3: eine Perspektivdarstellung mehrerer nebeneinander angeordneter, aus einer Leiterplatte ausgeformter Kontaktelemente in der ersten Ausführungsform,
- Fig. 4: eine Perspektivdarstellung zweier einen Aderverbinder bildender Kontaktelemente in der ersten Ausführungsform,
- Fig. 5: einen Längsschnitt durch ein aus einer Leiterplatte ausgebildetes Kontaktelement in der zweiten Ausführungsform
- Fig. 6 + 7: Perspektivdarstellungen von Kontaktelementen gemäß der zweiten Ausführungsform,
- Fig. 8: ein Detail des Kontaktelementes der zweiten Ausführungsform gemäß den Figuren 6 und 7,
- Fig. 9: die Draufsicht auf ein Kontaktelement in der dritten Ausführungsform,
- Fig. 10: ein vergrößertes Detail des Kontaktelementes gemäß Figur 9,
- Fig. 11: einen Längsschnitt durch den Kontaktschlitz des Kontaktelementes gemäß Figur 10,
- Fig. 12: eine Draufsicht auf den Kontaktschlitz des Kontaktelementes gemäß Figur 10,
- Fig. 13: eine Draufsicht auf eine Anschlußdose der Fernmeldetechnik mit eingebauter Leiterplatte mit Kontaktelementen gemäß der vierten Ausführungsform,
- Fig. 14: einen Querschnitt durch die Anschlußdose gemäß Figur 13 bei geöffneten Gehäusehälften,
- Fig. 15: einen Längsschnitt durch die Anschlußdose gemäß Figur 13,
- Fig. 16: eine Draufsicht auf die Stirnseite des Rastelementes für die Leiterplatte der Anschlußdose gemäß Figur 13,
- Fig. 17: einen Längsschnitt durch ein Kontaktelement in der fünften Ausführungsform,
- Fig. 18: eine Draufsicht auf das Rastelement des Kontaktelementes gemäß Figur 17,
- Fig. 19: einen Querschnitt durch eine Leiterplatte mit einem Kontaktelement gemäß der sechsten Ausführungsform,
- Fig. 20: eine Untersicht eines Druckstückes des Kontaktelementes gemäß Figur 19 und
- Fig. 21+22: Seitenansichten des Druckstückes gemäß Figur 20.

Das Kontaktelement 1 für elektrische Leiter 2, insbesondere für Kabeladern der Fernmeldetechnik, besteht aus zwei, einen Kontaktschlitz 3 zwischen sich einschließenden elektrisch leitfähigen Kontaktflächen 4, die aus einem Isolierstoff 5 ausgeformt und mit metallisierten Oberflächen 6 versehen sind. Der Isolierstoff 5 ist dabei zu blockartigen Erhebungen 7 ausgeformt, zwischen denen der V-förmige Kontaktschlitz 3 ausgebildet ist, dessen Basis 8 abgeflacht ist. Die Seitenflächen des V-förmigen Kontaktschlitzes 3 und die angrenzenden Bereiche der Erhebungen 7 sind zur Bildung der Kontaktflächen 4 mit den metallischen Oberflächen 6 versehen. Die metallisierten Oberflächen 6 sind durch Aufdampfen oder elektrolytische Abscheidung von leitfähigem metallischen Material auf den Oberflächen des Isolierstoffes 5 gebildet.

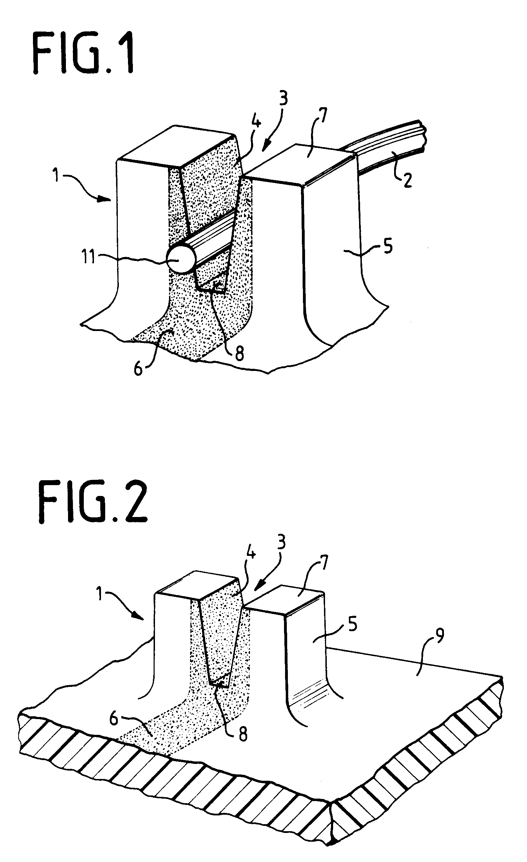

Wie es Fig. 1 zeigt, ist die Leiterseele 11 des Leiters 2 abisoliert und zwischen die Kontaktflächen 4 des sich konisch verjüngenden V-förmigen Kontaktschlitzes 3 eingeklemmt. Dabei wird eine elektrische Kontaktverbindung zwischen der Leiterseele 11 des Leiters und der metallischen Oberfläche 6 geschaffen, welche in nicht näher dargestellter Weise zu einem Leiterbahnverknüpfungspunkt geführt ist.

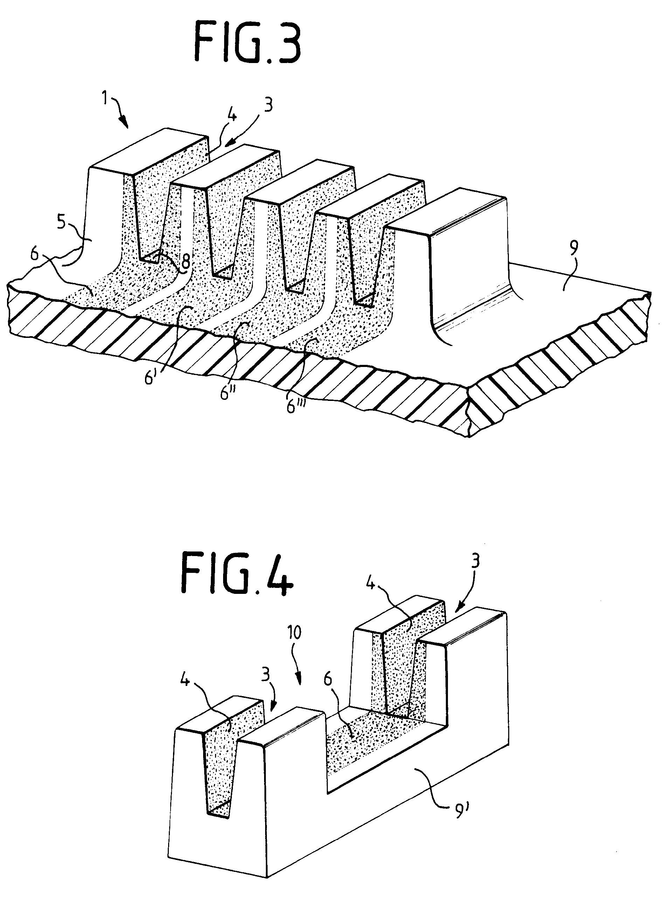

Gemäß Fig. 2 befinden sich die Erhebungen 7 auf einen Träger 9, der aus einer Leiterplatte gebildet sein kann. Gemäß Fig. 3 sind mehrere, je einen Kontaktschlitz 3 zwischen sich einschließende Kontaktflächen 4 auf einem Träger 9 nebeneinander angeordnet, wobei die Kontaktflächen 4 nebeneinander liegender Kontaktschlitze 3 mit elektrisch voneinander getrennten metallisierten Oberflächen 6, 6′, 6˝, 6‴ versehen sind. Auch dieses Kontaktelement 1 kann auf einer durch den Träger 9 gebildeten Leiterplatte angeordnet sein.

Dabei sind die Erhebungen 7 des die Leiterplatte bildenden Trägers 9 einstückig mit dem die Leiterplatte bildenden Träger 9 ausgeformt.

Gemäß Fig. 4 sind zwei Paare 10 von je einen Kontaktschlitz 3 zwischen sich einschließenden Kontaktflächen 4 auf einem Träger 9, angeordnet und zur Ausbildung eines Aderverbinders mit elektrisch miteinander verbundenen metallisierten Oberflächen 6 versehen. (Fig. 4).

Die bisher beschriebenen Kontaktelemente der ersten Ausführungsform erfordern ein vorheriges Abisolieren der Leiter 2 und damit ein Freilegen der Leiterseele 11, die in den Kontaktschlitz 3 der Kontaktelemente 1 eingeklemmt wird. Dabei können die Seitenflächen des Kontaktschlitzes 3 die Leiterseele 11 durch Reibungskontakt halten. Andererseits kann auch ein Lötvorgang zwischen der Leiterseele 11 und der metallisierten Kontaktfläche 4 erfolgen. Die Anwendung der bisher beschriebenen Kontaktelemente 1 erfolgt im wesentlichen bei Leiterplatten, die aus Kunststoff ausgeformt werden, wobei gleichzeitig die Erhebungen 7 mit ausgeformt werden können. Die metallisierten Oberflächen 6 werden durch Elektroplatieren oder dergleichen hergestellt und können gleichzeitig mit der Ausbildung der Leiterbahnen auf der Leiterplatte hergestellt werden.

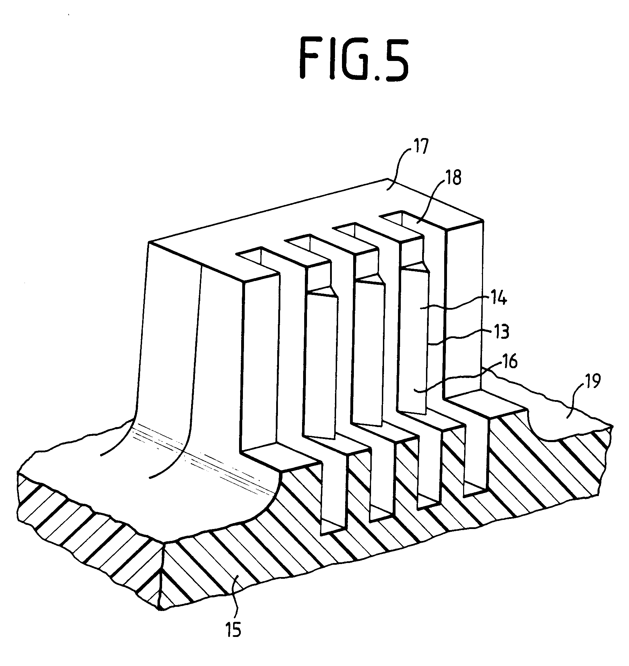

Die nachfolgend beschriebenen Ausführungsformen des Kontaktelementes erfordern kein Abisolieren der Leiter 2, sondern bilden Schneid-Klemm-Kontaktelemente, an welche die Leiter 2 ohne Abisolieren angeschlossen werden können. So sind bei der zweiten Ausführungsform gemäß den Fig. 5 bis 8 zum Einschneiden der Ummantelung 12 der Leiter 2 an den Kontaktflächen 14 aus dem Isolierstoff 15 ausgeformte, mit metallisierten Oberflächen 16 versehene, gegenüberliegende Schneidkanten 13 angeordnet. Diese sind im Querschnitt dreieckförmig ausgebildet und einstückig mit dem Isolierstoff 15 des das Kontaktelement bildenden Trägers 19 ausgebildet. Da die dreieckförmigen Schneidkanten 13 aus dem Isolierstoff 15 des Kontaktelementes einstückig ausgeformt sind, können die Schneidkanten 13 in einem geringen, zulässigen Maße federnd ausgebildet sein. Zur Ausbildung eines gewünschten zulässigen Federweges der Schneidkanten 13 können diese auch aus freigeschnittenen, dreieckförmigen Kunststofflappen ausgeformt sein. In jedem Falle muß sichergestellt sein, daß die dreieckförmigen Schneidkanten 13 nach dem Einschneiden der Ummantelung 12 des Leiters 2 klemmend/federnd an der Leiterseele 11 anliegen. Die metallisierten Oberflächen 16 kommen hierbei in Berührungskontakt mit mit der Leiterseele 11, so daß eine elektrische Kontaktverbindung herstellbar ist.

Wie es die Fig. 5 zeigt können zwischen den Schneidkanten 13 Freistiche 18 in den Erhebungen 17 ausgebildet sein, welche einstückig aus dem Isolierstoff 15 des Trägers 19 ausgeformt sind.

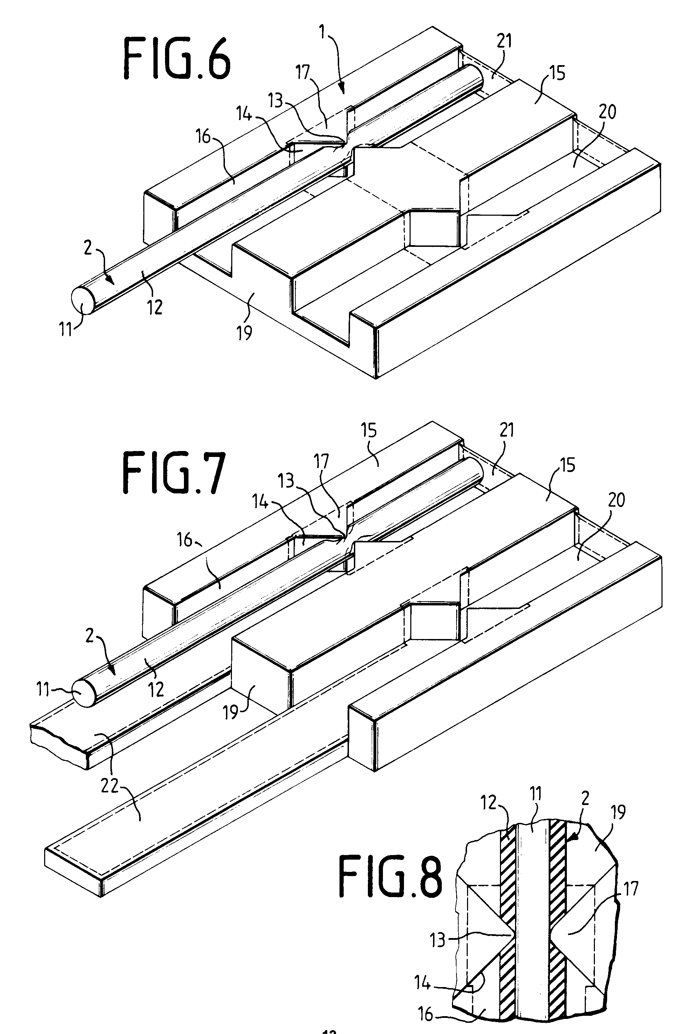

Wie es die Fig. 6 zeigt, sind die gegenüberliegenden Schneidkanten 13, welche die Kontaktflächen 14 bilden innerhalb von in den Isolierstoff 15 eingelassenen Kanälen 20 ausgebildet, in welche je ein Leiter 2 eingesetzt ist. Die metallisierten Oberflächen 16 beider Kanäle 20 sind dabei leitend miteinander verbunden, so daß hierduch ein Aderverbinder geschaffen ist. An den freien Enden der Kanäle 20 sind Schneidemesser 21 eingesetzt, welche die Leiter 2 beim Eindrücken in die Schneidkanten 13 mittels eines nicht näher dargestellten Werkzeuges gleichzeitig abtrennen.

Gemäß Fig. 7 können zusätzlich Steckerzungen 22 aus dem Isolierstoff 15 des Kontaktelementes ausgebildet sein.

Die Fig. 8 zeigt ein vergrößertes Detail zweier gegenüberliegender Schneidkanten 13, welche unter Einschneiden der Ummantelung 12 des Leiters 2 mit ihren metallisierten Oberflächen 16 mit der Leiterseele 2 in elektrischem Kontakt stehen.

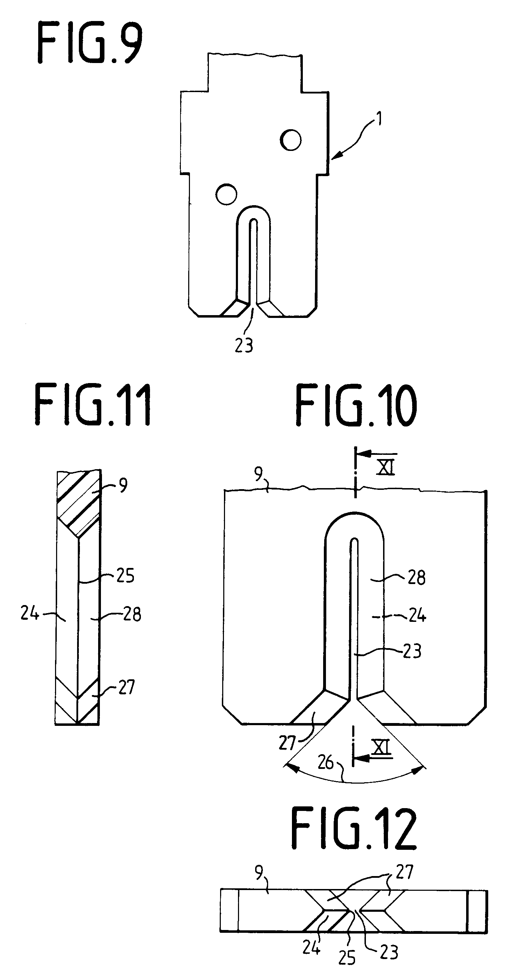

Gemäß der in den Figuren 9 bis 12 dargestellten dritten Ausführungsform sind die Kontaktflächen 24 als metallisierte Schneiden 25 des Kontaktelementes ausgeformt, wobei den Schneiden 25 unter einem V-förmigen Öffnungswinkel 26 stehende Vorschneiden 27 zugeordnet sind. Das Kontaktelement gemäß der dritten Ausführungsform ist zum Einsetzen in die Kunststoffkörper von Anschluß- oder Trennleisten oder Steckern bestimmt oder kann mit diesen einstückig ausgeformt sein. Die Kontaktflächen 24 der Schneiden 25 sind mit metallisierten Oberflächen 28 versehen. Diese sind zu einem nicht näher dargestellten Anschlußpunkt geführt. In nicht dargestellter Weise kann ein Kontaktelement gemäß der dritten Ausführungsform auch zwei oder mehrere Kontaktschlitze 23 aufweisen, deren Kontaktflächen 24 über gemeinsame metallisierte Oberflächen 28 miteinander verbunden sind.

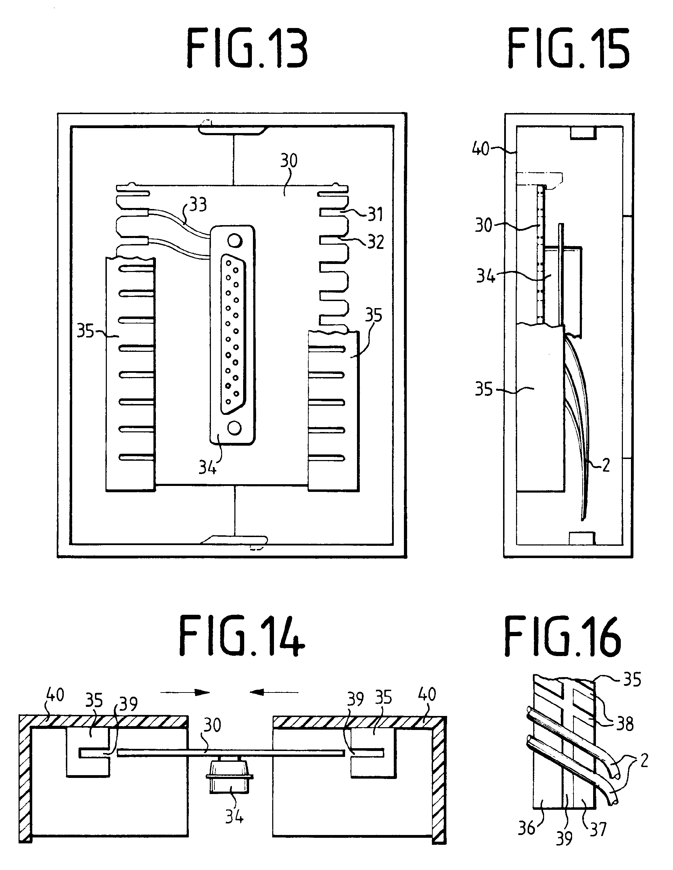

Die in den Figuren 13 bis 16 dargestellte vierte Ausführungsform des Kontaktelementes umfaßt eine Leiterplatte 30, in deren beiden Randbereichen kammartig Klemmschlitze 31 eingebracht sind, die im Querschnitt länglich rechteckig ausgeführt sind. Mindestens der Innenbereich der Klemmschlitze 31 ist mit einer metallisierten Oberfläche 32 versehen, die über Leiterbahnen 33 mit den einzelnen Steckkontakten eines Steckers 34 verbunden sind, der etwa mittig auf die Leiterplatte 30 montiert ist. Auf beide Randbereiche der Leiterplatte 30 ist je ein U-förmiges Rastelement 35 aufgesteckt, das mit in beiden Schenkeln 36, 37 gegeneinander versetzt ausgebildeten Schlitzen 38 versehen ist. Die U-förmigen Rastelemente 35 sind auf die Randbereiche der Leiterplatte 30 unter einer Schneid-Klemm-Kontaktierung der Leiter 2 aufrastbar, wobei die Ummantelung 12 der Leiter 2 an gegenüberliegenden Stellen derart von den Kanten der Klemmschlitze 31 eingeschnitten wird, daß deren metalisierte Oberfläche 32 in leitfähigen Kontakt mit der Leiterseele 2′ der Leiter 2 kommen.

Die Fig. 16 zeigt eine Draufsicht auf ein U-förmiges Rastelement 35 mit den schräg verlaufenden Schlitzen 38 in den beiden Schenkeln 36, 37, die den inneren Längsschlitz 39 begrenzen. In die Schlitze 38 werden die nicht abisolierten Leiter 2 eingelegt, die somit unter einem Winkel zum Längsschlitz 39 liegen, welcher auf die Randbereiche der mit den Klemmschlitzen 31 versehenen Leiterplatte 30 aufgesteckt wird, wodurch die Schneid-Klemm-Kontaktierung erfolgt.

Die Fig. 14 zeigt die Anordnung der U-förmigen Rastelemente 35 innerhalb von zwei Gehäusehalbschalen 40, die derart ausgebildet sind, daß das aus den beiden Gehäusehalbschalen 40 gebildete Gehäuse bei auf die Randbereiche der Leiterplatte 30 aufgeschobenen Rastelementen 35 geschlossen ist.

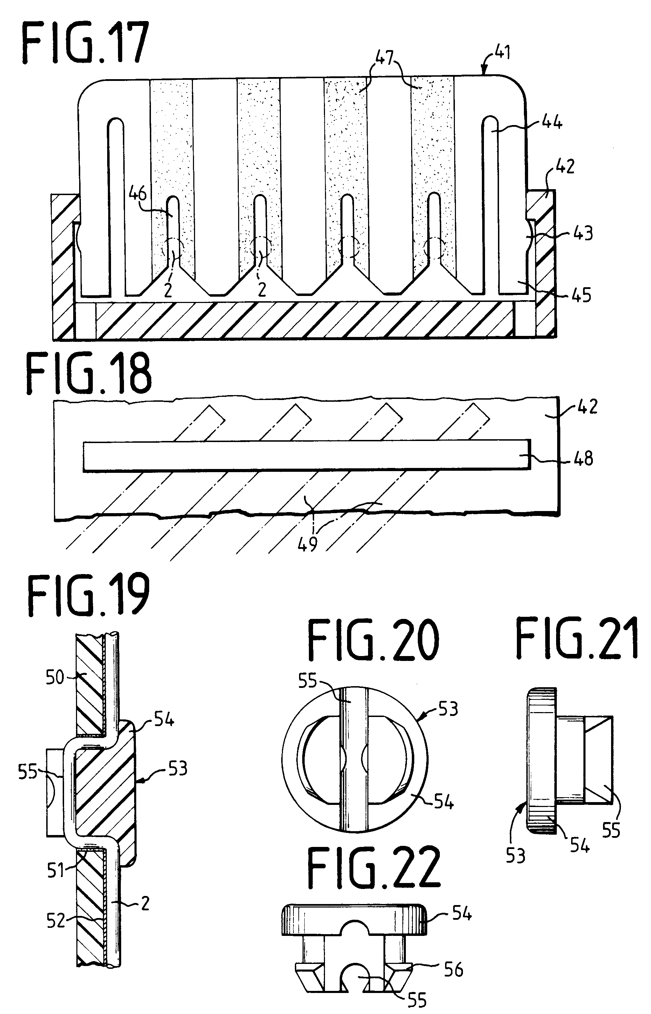

Die Figuren 17 und 18 zeigen als fünfte Ausführungsform ein Kontaktelement, das aus einer kammartigen Leiterplatte 41 und einem Rastelement 42 gebildet ist, das auf den freien Randbereich der Leiterplatte 41 aufgesteckt ist und hinter Rastnasen 43 der Leiterplatte 41 arretiert ist. Zur Erzeugung einer Federwirkung ist die Leiterplatte 41 im Bereich der Rastnasen 43 mit am Rand parallelen Längsschlitzen 44 versehen, so daß die hierdurch freigeschnittenen Außenschenkel 45 der Leiterplatte 41 federnd ausgebildet sind.

Zwischen den äußeren Längsschlitzen 44 sind weitere Kontaktschlitze 46 in der Leiterplatte 41 ausgebildet, welche mit metallisierten Oberflächen 47 versehen sind, die bis in die Kontaktschlitze 46 hineinragen.

Das Rastelement 42 ist mit einem Längsschlitz 48 und mit hierzu unter einem Winkel angeordneten Querbohrungen 49 versehen, in welche die Leiter 2 eingeschoben sind. Durch Eindrücken der Leiterplatte 41 in das Rastelement 42 werden die Ummantelungen 12 der Leiter 2 von den Kanten der Kontaktschlitze 46 eingeschnitten, wobei eine elektrische Kontaktierung zwischen den Leiterseelen 11 und den metallisierten Oberflächen der Leiterplatte 41 gestellt ist. Anstelle der Querbohrungen 49 können auch Nuten zum Einlegen der Leiter 2 vorgesehen werden.

Die in den Figuren 19 bis 22 dargestellte sechste Ausführungsform des Kontaktelementes umfaßt eine Leiterplatte 50 mit einer Bohrung 51, die mit metallisierten Oberflächen 52 versehen sind. Zum Eindrücken in die Bohrung 51 ist ein druckknopfartiges Rastelement 53 vorgesehen, daß mit einer Druckfläche 54, einer Aufnahmenut 55 auf der der Druckfläche 54 gegenüberliegenden Stirnseite und Rasten 50 versehen ist, deren Abstand zur Kante der Druckfläche 54 etwa der Dicke der Leisterplatte 50 entspricht.

In die Aufnahmenut 55 des druckknopfartigen Rastelementes 53 wird ein nicht abisolierter Leiter 2 eingelegt und mittels Einwirkung auf die Druckfläche 54 in die Bohrung 51 eingedrückt, wie es Fig. 19 dargestellt ist. Dabei wird der Leiter 2 U-förmig verformt, wobei die scharfen Kanten der Bohrung 51 in die Leiterseele 11 einschneiden und die metallisierte Oberfläche 52 in elektrischen Kontakt mit der Leiterseele 11 gebracht wird. Die Rasten 56 hintergreifen beim Austreten aus der Bohrung 51 die rückwärtige Seite der Leiterplatte 50, wodurch die Kontaktverbindung gesichert ist.

## Patentansprüche

1. Kontaktelement für elektrische Leiter, insbesondere zum Anschließen von Kabeladern der Fernmeldetechnik an Bauelemente, wie z.B. Leiterplatten, Anschluß- und Trennleisten und Aderverbinder, aus einem Isolierstoff mit zwei einen Klemmschlitz zwischen sich einschließenden elektrisch leitfähigen Kontaktflächen,
**dadurch gekennzeichnet,**
daß die Kontaktflächen (4) des Kontaktelementes (1) mit metallisierten Oberflächen (6,16,28,32,47,52) zum Klemmkontaktieren des elektrischen Leiters (2) versehen sind.

2. Kontaktelement nach Anspruch 1,
**dadurch gekennzeichnet,**
daß die Kontaktfläche (4) zur Aufnahme abisolierter Leiter (2) mit einem sich konisch verjüngenden Kontaktschlitz (3) versehen ist.

3. Kontaktelement nach Anspruch 2,
**dadurch gekennzeichnet,**
daß mehrere, je einen Kontaktschlitz (3) einschließende Kontaktflächen (4) auf einem Träger (5) nebeneinander angeordnet sind und daß die Kontaktflächen (4) nebeneinander liegender Kontaktschlitze (3) mit elektrisch voneinander getrennten metallisierten Oberflächen (6) versehen sind.

4. Kontaktelement nach Anspruch 1 oder Anspruch 2,
**dadurch gekennzeichnet,**
daß die Kontaktflächen (4) an Erhebungen (7) einer Leiterplatt e ausgebildet und einstückig mit der Leiterplatte ausgeformt sind.

5. Kontaktelement nach Anspruch 2,
**dadurch gekennzeichnet,**
daß zwei Paare (10) von je einen Kontaktschlitz (3) zwischen sich einschließenden Kontaktflächen (4) auf einem Träger (9) angeordnet und zur Ausbildung eines Aderverbinders mit elektrisch miteinander verbundenen metallisierten Oberflächen (16) versehen sind.

6. Kontaktelement nach einem der Ansprüche 1 - 5,
**dadurch gekennzeichnet,**
daß zum Einschneiden der Ummantelung (12) der Leiter (2) an den Kontaktflächen (4) aus dem Isolierstoff ausgeformte, mit metallisierten Oberflächen (16) versehene, gegenüberliegende Schneidkanten (13) angeordnet sind.

7. Kontaktelement nach Anspruch 6,
**dadurch gekennzeichnet,**
daß die Schneidkanten (13) im Querschnitt dreieckförmig ausgebildet sind.

8. Kontaktelement nach Anspruch 7,
**dadurch gekennzeichnet,**
daß die Schneidkanten (13) federnd ausgebildet sind.

9. Kontaktelement nach Anspruch 8,
**dadurch gekennzeichnet,**
daß die federnden Schneidkanten (13) aus Winkelstücken gebildet sind, die aus dem Isolierstoff ausgeformt sind.

10. Kontaktelemente nach einem der Ansprüche 1 - 9,
**dadurch gekennzeichnet,**
daß die Kontaktflächen (4) an innerhalb eines Klemmschlitzes ausgeformten Kontaktschenkeln zwischen Klemmstegen für die Leiter (2) ausgebildet sind.

11. Kontaktelement nach Anspruch 10,
**dadurch gekennzeichnet,**
daß die Kontaktschenkel auf einer Leiterplatte aus Kunststoff angeordnet und einstückig mit dieser ausgeformt sind.

12. Kontaktelement nach einem der Ansprüche A1 - 11,
**dadurch gekennzeichnet,**
daß die Kontaktflächen (24) als metallisierte Schneiden (25) eines Kontaktelementes ausgeformt sind, wobei den Schneiden (25) unter einem V-förmigen Öffnungswinkel (26) stehende Vorschneiden (27) zugeordnet sind.

13. Kontaktelement nach einem der Ansprüche 1 - 12,
**dadurch gekennzeichnet,**
daß die mit metallisierten Oberflächen (32) versehenen Kontaktflächen (4) beidseits von in den Randbereich einer Leiterplatte (30) kammartig eingebrachten Klemmschlitzen (31) angeordnet sind und daß ein U-förmiges Rastelement (35) mit in beiden Schenkeln 36,37) gegeneinander versetzt ausgebildeten Schlitzen (38) vorgesehen ist, das auf den Randbereich der Leiterplatte (30) unter einer Schneid-Klemm-Kontaktierung der Leiter (2) aufrastbar ist.

14. Kontaktelement nach Anspruch 13,
**dadurch gekennzeichnet,**
daß die Klemmschlitze (31) auf zwei gegenüberliegenden Randbereichen der Leiterplatte (30) angeordnet und zwei U-förmige Rastelemente (35) vorgesehen sind und daß die Rastelemente (35) innerhalb von Gehäusehalbschalen (40) derart gelagert sind, daß das Gehäuse bei auf die Randbereiche der Leiterplatte (30) aufgeschobenen Rastelementen (35) geschlossen ist.

15. Kontaktelement nach einem der Ansprüche 1 - 12,
**dadurch gekennzeichnet,**
daß die mit metallisierten Oberflächen (32,52) versehenen Kontaktflächen (4) auf gegenüberliegenden Seiten der Bohrung (51) einer Leiterplatte (50) angeordnet sind und daß ein druckknopfartiges Rastelement (53) zum Eindrücken eines Leiters (2) in die Bohrung (51) vorgesehen ist.

## Claims

1. A contact element for electrical conductor, characterised by that the contact surfaces (4) of the contact element (1) are provided with metallised surfaces (6, 16, 28, 32, 47, 52) for establishing an insulation displacement contact with the electrical conductor (2).

2. A contact element according to claim 1, characterised by that the contact surface (4) for receiving stripped conductors (2) is provided with a conical contact slot (3).

3. A contact element according to claim 2, characterised by that several contact surfaces (4) each including a contact slot (3) are disposed side-by-side on a support (5), and that the contact surfaces (4) of contact slots (8) disposed side-by-side are provided with electrically separated metallised surfaces (6).

4. A contact element according to claim 1 or 2, characterised by that the contact surfaces (4) are formed at elevations (7) of a printed-circuit boar and are made as one piece together with the printed-circuit board.

5. A contact element according to claim 2, characterised by that two pairs (10) of contact surfaces (4) each including a contact slot (3) therebetween are disposed on a support and are provided with electrically connected metallised surfaces (16) for forming a wire connector.

6. A contact element according to one of claims 1 to 5, characterised by that for cutting into the jacket (12) of the conductors (2), opposed contact elements (13) formed of the insulating material and provided with metallised surfaces (16) are disposed at the contact surfaces (4).

7. A contact element according to claim 6, characterised by that the contact elements (13) have a triangular cross-section.

8. A contact element according to claim 7, characterised by that the contact elements (13) are resilient.

9. A contact element according to claim 8, characterised by that the resilient contact slots (13) are formed of angled pieces made of the insulating material.

10. A contact element according to one of claims 1 to 9, characterised by that the contact surfaces (4) are provided at contact legs formed within a clamping slot between clamping webs for the conductors (2).

11. A contact element according to claim 10, characterised by that the contact legs are disposed on a printed-circuit board of plastic and are made as one piece therewith.

12. A contact element according to one of claims 1 to 11, characterised by that the contact surfaces (24) are formed as metallised cutters (25) of a contact element, pre-cutters (27) having a V-shaped opening angle being assigned to said cutters (25).

13. A contact element according to one of claims 1 to 12, characterised by that the contact surfaces (4) provided with metallised surfaces (32) are disposed on either side of comb-type clamping slots (31) provided at the border areas of a printed-circuit board (30), and that a U-shaped latch element (35) is provided with slots (38) being offset in both legs (36, 37), said latch element being latchable onto the border area of the printed-circuit board (30) and establishing an insulation displacement contact of the conductors.

14. A contact element according to claim 13, characterised by that the clamping slots (31) are disposed on two opposed border areas of the printed-circuit board (30), and that two U-shaped latch elements (35) are provided, and that the latch elements (35) are supported within the housing half-shells (40) such that the housing is closed when the latch elements (35) are slid onto the border areas of the printed-circuit board (30).

15. A contact element according to one of claims 1 to 12, characterised by that the contact surfaces (4) provided with metallised surfaces (32, 52) are disposed on opposed sides of the borehole (51) of a printed-circuit board (50), and that a pushbutton-type latch element (53) is provided for pressing-in a conductor (2) into the borehole (51).

## Revendications

1. Elément de contact pour conducteur électrique, en particulier pour le raccordement de fils de câble de la télécommuncation à des composants, comme p.ex. cartes imprimées, réglettes de connexion et de coupure et connecteurs de fils, comprenant une matière isolante avec deux surfaces de contact conductives électriquement incluant une fente de serrage,
caractérisé en ce que les surfaces de contact (4) de l'élément de contact (1) sont poruvues de surfaces métallisées (6, 16, 28, 32, 47, 52) pour établir une connexion de contact de coupure et de serrage du conducteur (2) électrique.

2. Elément de contact selon la revendication 1,
caractérisé en ce que la surface de contact (4) est pourvue d'une fente de contact (3) conique pour loger des conducteurs (2) dénudés.

3. Elément de contact selon la revendication 2,
caractérisé en ce que plusieurs surfaces de contact (4) chacune incluant une fente de contact (3) sont disposées l'une à côté de l'autre sur un support (5) et que les surfaces de contact (4) de fentes de contact (4) disposées l'une à côté de l'autre sont pourvues de surfaces métallisées (6) séparées électriquement.

4. Elément de contact selon la revendication 1 ou 2,
caractérisé en ce que les surfaces de contact (4) sont prévues à des élévations (7) d'une carte imprimée et sont formées en une pièce avec la carte imprimée.

5. Elément de contact selon la revendication 2,
caractérisé en ce que deux paires (10) de surfaces de contact (4) chacune incluant une fente de contact (3) sont disposées sur un support et sont pourvues de surfaces métallisées (16) liées électriquement l'une à l'autre pour former un connecteur de fils.

6. Elément de contact selon une des revendications 1 à 5,
caractérisé en ce que pour couper la gaine (12) des conducteurs (2), des arêtes coupantes (13) opposées formées de la matière isolante et pourvues de surfaces métallisées (16) sont disposées aux surfaces de contact (4).

7. Elément de contact selon la revendication 6,
caractérisé en ce que les arêtes coupantes (13) ont une coupe en travers triangulaire.

8. Elément de contact selon la revendication 7,
caractérisé en ce que les arêtes coupantes (13) sont élastiques.

9. Elément de contact selon la revendication 8,
caractérisé en ce que les arêtes coupantes (13) élastiques sont formées de pièces angulaires en la matière isolante.

10. Elément de contact selon une des revendications 1 à 9,
caractérisé en ce que les surfaces de contact (4) sont formées a des branches de contact formées au-dedans d'une fente de serrage entre des pièces de serrage pour les conducteurs (2).

11. Elément de contact selon la revendication 10,
caractérisé en ce que les branches de contact sont disposées sur une carte imprimée en matière plastique et sont formées en une pièce avec celle-ci.

12. Elément de contact selon une des revendications 1 à 11,
caractérisé en ce que les surfaces de contact (24) sont formées comme des couteaux (25) métalliques d'un élément de contact, auxdits couteaux (25) étant associés des pré-couteaux (27) ayant un angle d'ouverture (26) en forme de V.

13. Elément de contact selon une des revendications 1 à 12,
caractérisé en ce que les surfaces de contact (4) pourvues de surfaces métallisées (32) sont disposés des deux côtés de fentes de serrage (31) en forme de peigne prévues dans le domaine de bord d'une carte imprimée (30) et qu'un élément d'encliquetage (35) en U est prévu ayant des fentes (38) décalées dans les deux branches (36, 37), ledit élément d'encliquetage (35) pouvant être encliqueté sur le domaine de bord de la carte imprimée (30) ainsi formant un contact de coupure et de serrage.

14. Elément de contact selon la revendication 13,
caractérisé en ce que les fentes de serrage (31) sont disposées sur deux domaines de bord opposés de la carte imprimée (30) et que les éléments d'encliquetage (35) sont logés au-dedans de moitiés de boîtier (40), de sorte que le boîtier soit fermé, si les éléments d'encliquetage (35) sont placés sur les domaines de bord de la carte imprimée (30).

15. Elément de contact selon une des revendications 1 à 12,
caractérisé en ce que les surfaces de contact (4) pourvues de surfaces métallisées (32, 52) sont disposées sur des côtés opposés de la forure (51) d'une carte imprimée (50) et qu'un élément d'encliquetage (53) en forme de bouton-poussoir est prévu pour pousser un conducteur (2) dans la forure (51).
